Europäisches Patentamt

European Patent Office

Office européen des brevets

(19)

(11) Publication number: **0 025 660**
**A1**

(12) **EUROPEAN PATENT APPLICATION**

(21) Application number: **80303016.2**

(22) Date of filing: **29.08.80**

(51) Int. Cl.³: **H 03 K 17/78**

(30) Priority: **31.08.79 JP 111983/79**

(43) Date of publication of application: **25.03.81**
**Bulletin 81/12**

(84) Designated Contracting States: **AT BE CH DE FR GB IT LI LU NL SE**

(71) Applicant: **FUJITSU LIMITED, 1015, Kamikodanaka Nakahara-ku, Kawasaki-shi Kanagawa 211 (JP)**

(72) Inventor: **Takase, Shintaro, A-309. Green-Corpo-Ohkurayama 931-1, Mamedo-cho, Kohoku-ku Yokohama-shi, Kanagawa 222 (JP)**

(74) Representative: **Overbury, Richard Douglas et al, HASELTINE LAKE & CO Hazlitt House 28 Southampton Buildings Chancery Lane, London WC2A 1AT (GB)**

(54) **An optical coupling device.**

(57) A photothyristor (1) with a photodetector (2) is connected in parallel between gate (G) and cathode (K) of the photothyristor (1). The photodetector (2) is such that its impedance is decreased when it is struck by incident light. The photothyristor (1) is turned OFF when the impedance of the photodetector (2) decreases. The photodetector (2) can be a bipolar phototransistor (5) or an enhancement type photo-field effect transistor (6). A light emitting diode LED$_2$ is arranged opposite to the photodetector (2) in the optical coupling device. When light from light emitting diode LED$_2$ is incident on photodetector (2) the photothyristor is turned OFF.

-1-

AN OPTICAL COUPLING DEVICE.

The present invention relates to an optical device, e.g. a photocoupler or a photoisolator, utilising a thyristor.

As is generally known in the art to which this invention pertains, an optical coupling device, e.g. a photocoupler, utilizing a photothyristor has been widely used as a switching device or as an isolator. In an optical coupling device of this kind, a photodetector element constituted by a photothyristor, which can be turned ON by incident light, has been employed. However, to turn OFF such an optical coupling device a commutator circuit has had to be provided to turn OFF the anode current for example of the photothyristor. In other words, it has been necessary to decrease the anode current to below a minimum holding current, or to reverse bias the connection between the anode and cathode, in order to turn OFF the optical coupling device which has been turned ON by incident light. Such a commutator circuit has been complex and has occupied a substantial amount of space, and this fact has thwarted attempts to replace electromechanical relays in crossbar switches by optical coupling devices.

According to the present invention, there is provided an optical coupling device comprising a photothyristor, characterised in that a photodetector element, the impedance /is decreased when light is incident thereupon
of which

is connected in parallel between a gate and a cathode/ or an anode of the photothyristor.

According to the present invention there·is provided an optical coupling device comprising photosensitive means having first and second main terminals,which means are placed in a first state (to pass or to block current flowing between the first and second main terminals) when light is incident thereupon, the photo-sensitive means also having a control terminal, with a· photodetector element connected in parallel between the control terminal and one of the first and second main terminals such that when light is incident upon the photodetector element the resulting change in impedance thereof causes the photosensitive means to change from the first state to a second state (i.e. to block or to pass current flowing between first and second main terminals).

An embodiment of the present invention can provide a switch that may be operated by incident light which can, for example, replace electromechanical relays used in crossbar switches.

More particularly, an embodiment of the present invention can provide an optical coupling device which can be turned ON and OFF by incident light without the need for a commutator for turning OFF anode current of a photothyristor of the device. This is conceived by diverting the fundamentals of the gate-turn-off (GTO) thyristor.

In an optical coupling device, e.g. a photocoupler, embodying this invention a photodetector element is connected in parallel between gate and cathode of a photothyristor.

In one embodiment of the invention, the photodetector element is a bipolar phototransistor, and there is provided opposite to the transistor an element which emits light when a signal to turn the photothyristor OFF is applied thereto.

In another embodiment of the invention, the

-3-

photodetector element is an enhancement type photo-field effect transistor (FET), and an element that emits light when a signal to turn the photothyristor OFF is applied to it is arranged opposite to the transistor.

Reference will be made, by way of example, to the accompanying drawings in which:-

Fig. 1 is a schematic illustration of the circuit illustrating fundamental features of an optical coupling device according to the present invention;

Fig. 2 is a schematic illustration of an equivalent circuit of a first embodiment of the present invention;

Fig. 3 is a schematic illustration of an equivalent circuit of a second embodiment of the invention;

Figs. 4 and 5 are schematic waveform diagrams illustrating the modes of operation of the first and second embodiments;

Fig. 6 is a schematic illustration of a circuit used in connection with experiments concerning the present invention;

Fig. 7 is a schematic waveform diagram illustrating ON and OFF states of a thyristor current in connection with the circuit of Fig. 6;

Figs. 8 and 9 are respective graphical illustrations of measured maximum thyristor currents which could be turned OFF in experimental circuits; and

Fig. 10 is a graphical illustration of the relationship between the current driving the photodetector element and the maximum thyristor current which could be turned OFF in experimental circuits relating to the present invention.

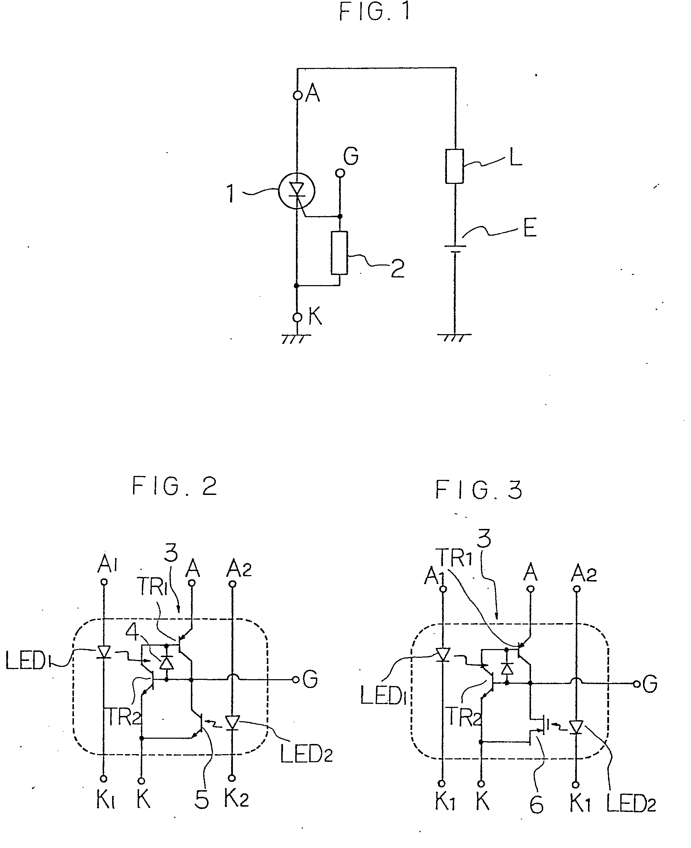

Fig. 1 illustrates the principle of an optical coupling device embodying the present invention. In Fig. 1 there is shown a known photothyristor 1 with an anode A and a cathode K to be connected in a conventional power source circuit, and a gate G for control signal input. In Fig. 1, a load L is connected between anode A of the photothyristor and a power source E, and cathode K of the photothyristor is connected to earth level.

A photodetector element 2 is connected in parallel between gate G and cathode K of the photothyristor. In the circuit shown in Fig. 1, when light irradiates the photothyristor 1, the photothyristor 1 is turned ON and a current flows from anode A to cathode K to drive load L. In this state, when light strikes or irradiates the photodetector element 2, the impedance of the element 2 is decreased to place the photothyristor 1 in an OFF state by effectively drawing electric charge in the base or gate of a transistor used as the photodetector element (e.g. a N-P-N transistor).

There is shown in Fig. 2 a first embodiment of the present invention, based on the principle illustrated in Fig. 1. In Fig. 2, an optical coupling device 3 comprises a photothyristor 1 and a photodetector element 2 and light emitting diodes $LED_1$ and $LED_2$.

The photothyristor 1 is represented in Fig. 2 by an equivalent circuit comprising a P-N-P type transistor $TR_1$, a photodiode 4 and a N-P-N type transistor $TR_2$. Transistors $TR_1$ and $TR_2$ are arranged in such a manner that the base of the transistor $TR_1$ is connected in series to the collector of transistor $TR_2$, and the collector of transistor $TR_1$ is connected to the base of transistor $TR_2$, with photodiode 4 connected between the bases of two transistors.

Thus, the emitter of transistor $TR_1$ corresponds to anode A (see Fig. 1) and the emitter of transistor $TR_2$ corresponds to cathode K (see Fig. 1) of the photothyristor 1 of Fig. 1.

Further, the collector of transistor $TR_1$ and the base of transistor $TR_2$, which are connected, correspond to the gate G of Fig. 1. Phototransistor 5 is used as the photodetector element 2 and is connected between gate G and cathode K.

The optical coupling device 3 of Fig. 2 is constructed as a photocoupler, and a light emitting diode $LED_1$, having anode $A_1$ and cathode $K_1$, is arranged opposite the photodiode 4, with a light

emitting diode $LED_2$, having anode $A_2$ and cathode $K_2$, arranged opposite the phototransistor 5.

In this first embodiment, the photodetector element 5 is placed in parallel between a P-type gate G and a N-type cathode K of a four layer PNPN structure photothyristor 1 (represented in Fig. 2, by the two transistors $TR_1$, $TR_2$ and photodiode 4), but the invention is not limited to such an arrangement; for example a photodetector element may be connected in parallel, for example, between a N-type gate and a P-type anode.

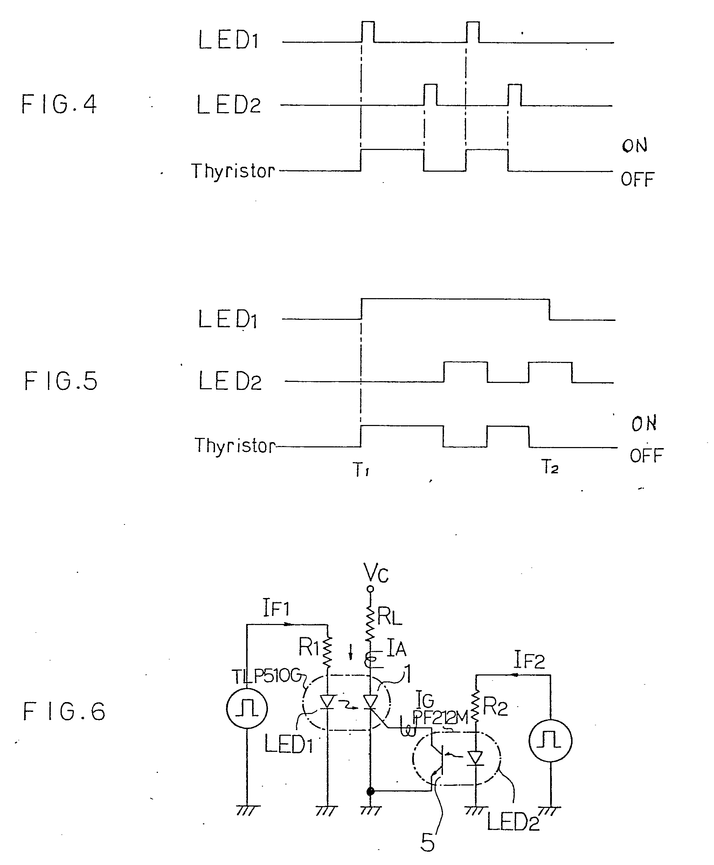

Next, details of the operation of the optical coupling device embodying the invention will be explained, reference being made to the waveforms illustrated in Fig. 4 and Fig. 5 for this purpose.

In order to bring about an ON state, current is caused to flow between anode $A_1$ and cathode $K_1$ of light emitting diode $LED_1$ of Fig. 2, as illustrated in Fig. 4 for example, making $LED_1$ emit light. In terms of the equivalent circuit, photodiode 4 of the photothyristor, which is optically coupled to this light emitting diode $LED_1$, causes photocurrent to flow to the base of transistor $TR_2$ when the photodiode is struck by light from $LED_1$. Because of this, transistor $TR_2$ is turned ON and base current flows from transistor $TR_1$. When such current is produced, transistors $TR_1$ and $TR_2$ are turned ON, and because of this the base current of transistor $TR_2$ is supplied through the emitter and collector of transistor $TR_1$, and the base current of transistor $TR_1$ can flow through the collector and emitter of transistor $TR_2$. As a result, the entire circuit is latched and a current flows between anode A and cathode K independently of irradiation and non-irradiation of light emitting diode $LED_1$. Thus, the photothyristor 1 of Fig. 1 is turned ON.

Next, in order to bring about an OFF state of photothyristor 1, a current is caused to flow between anode $A_2$ and cathode $K_2$ of light emitting diode $LED_2$

corresponding to the photodetector element 5. The
photodetector element 5, when struck by light from
light emitting diode $LED_2$, is turned ON, and bypasses
(shunts) base current of transistor $TR_2$ to turn that
transistor OFF. Consequently, transistor $TR_1$ is turned
OFF with its base current cut off, and thus photothyristor 1 is turned OFF. This turn OFF of photothyristor 1 is realized even if incident light from light
emitting diode $LED_1$ is continuously present. Thus,
if, as illustrated in Fig. 5, light emitting diode $LED_1$
emits light continuously from time $T_1$ to time $T_2$,
during which light emitting diode $LED_2$ is turned ON
and OFF as shown, photothyristor 1 is turned OFF and ON
in accordance with operation of $LED_2$.

Fig. 3 shows a second embodiment of the present
invention. In Fig. 3 parts corresponding to those of
Fig. 2 are given the same reference numerals. As will
be apparent from a comparison of the embodiments of
Fig. 2 and Fig. 3, the second embodiment is different
from the first embodiment in that a N-channel, enhancement
type photo-field effect transistor (FET) 6, the characteristic impedance of which is decreased by incident light,
is used as photodetector element 2. This photodetector
element 6 is connected in parallel between gate G and
cathode K of the photothyristor 1 in a manner similar
to the connection of transistor 5 in the first
embodiment. (Again in Fig. 3, the photothyristor
1 is represented by an equivalent circuit).

When the photodetector element 6 is struck by light
from light emitting diode $LED_2$ for a predetermined
length of time, the element 6 maintains low impedance
and causes the photothyristor (i.e. transistors $TR_1$, $TR_2$
and photodiode 4) to be turned from an ON state to
an OFF state, by bypassing (shunting) plasma-like electric
charge in a base region of the photothyristor.

It may be pointed out here that, although photodetector element 2 is either a phototransistor or an N-
channel, enhancement type photo-field effect transistor in the first and second embodiments of the present invention illustrated above, other types of element may be selected as desired so long as the element has a characteristic such that its impedance is decreased by incident light.

Further, the equivalent circuit of the abovedescribed embodiments was taken to relate to a photothyristor but such a limitation is not necessary, and the equivalent circuit may be taken to relate to any photo-element or arrangement if that element may be turned OFF by decreasing the impedance between gate and cathode, as is the case with a photo triac, for example.

Results of experiments conducted in connection with the present invention will now be described with reference to Fig. 6. In the circuit of Fig. 6 $LED_1$, which is coupled with photothyristor 1, is fed with current through a resistor $R_1$. $LED_2$, which is coupled with photodetector element 5 (in this case a phototransistor),is fed with current through a resistor $R_2$. The photothyristor 1 is arranged to switch a current from source $V_c$ carried through a resistor $R_L$

There are schmatically indicated in Figure 6 means for sensing thyristor (anode) current $I_A$ and thyristor gate current $I_G$.

$I_{F1}$, $I_{F2}$ are the driving currents of light emitting diodes $LED_1$ and $LED_2$.

A photothyristor 1 used in the experiments was a product of Tokyo Shibaura Electric Co., Ltd. of Tokyo, Japan, known by the brand name TLP510G and having $V_{DRM}$ of 400 V and $I_{T(RMS)}$ of 150mA, and as a photodetector element 5, a product of Fujitsu Co., Ltd. of Tokyo, Japan, known by the brand name of PF212M was selected.

With

$I_{F1}$ = 10mA,

$I_{F2}$ = 100mA and

$I_A$ = 34mA

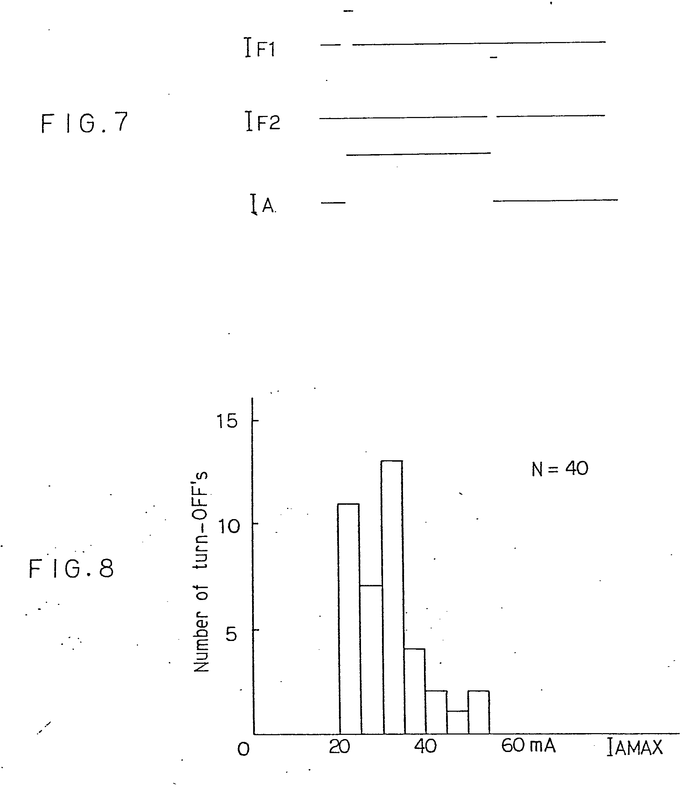

the thyristor 1 could be turned ON and OFF reliably, to switch the current $I_A$ ON and OFF. By way of explanation, it should be pointed out that Fig. 7 is a representation of photographs recorded by an oscillograph. It will be seen from Fig. 7 that when $LED_1$ was supplied with driving current $I_{F1}$ (= 10mA) the thyristor 1 was turned ON (i.e. $I_A$ goes to 34mA). When $LED_2$ was subsequently supplied with driving current $I_{F2}$ (=100mA) the thyristor 1 was turned OFF (i.e. $I_A$ cut off). The turn-ON time $t_{on}$ was approximately 20 $\mu$s, and turn-OFF time $t_{off}$ approximately 40 $\mu$s.

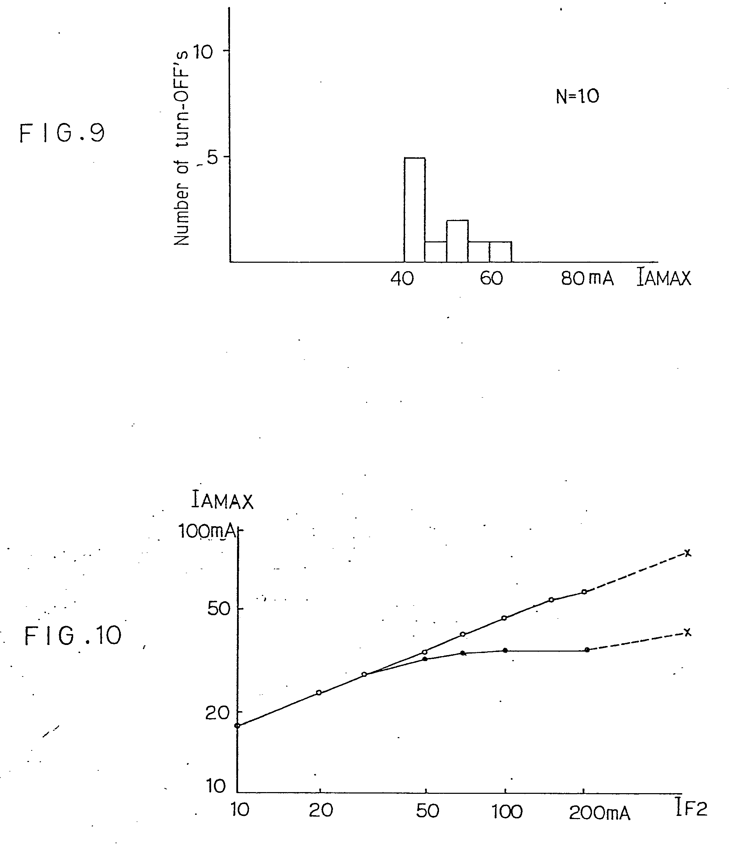

There is an upper limit to the value of thyristor current $I_A$ which can be turned OFF by the method used in the experiments, and results of measurements are shown in Figures 8 and 9 which shows ranges tested for turn-OFF's. Fig. 8 concerns the abovedescribed photothyristor TLP510G, and Fig. 9 conerns 2SF350, a thyristor made by Fujitsu Co., Ltd.

When the driving current $I_{F2}$ of light emitting diode $LED_2$ is decreased, maximum value of current $I_A$ that can be turned OFF decreases. This is illustrated in Fig. 10 in which the points indicated by circles concern thyristor 2SF350 and the points indicated by dots concern photothyristor TLP510G. The "X" marks show the conditions when gate and cathode are short-circuited.

In order to turn OFF the photothyristor 1, it is necessary to bring the transistors having NPN and PNP structures into non-saturated regions by extracting excess carriers in the transistor base, but it takes a determinate length of time designated by $t_{stg}$ to realize this. That is, taking the photothyristor 1 to be a four layer PNPN structure device, it may be useful to consider it to be equivalent to a PNP transistor (see $TR_1$ in Fig. 1) and an NPN transistor (see $TR_2$ in Fig. 2), together with a photodiode. The two middle layers $N_B, P_B$ of the four layer structure might then be said to correspond to the bases of the two transistors and the $P_B$-$N_B$ junction might be taken to correspond to the photodiode (see 4 in Fig.1). Excess carriers in the base in plasma state pass through the base layer and are extracted from near, from the region of, the gate electrode (of the thyristor) and are concentrated toward the central part of the cathode electrode of the thyristor, and the period of time taken until plasma in the base is concentrated to within the effective diffusion length $L_n$ of the minority carriers in the base layer represents a first stage, with a substantial part of $t_{stg}$ taken up by this first stage. The second stage is that period of time during which minority carriers are decreased until $P_B$-$N_B$ junction is no longer forward biased, and the duration of the second stage is normally small.

The turn OFF gain $\beta$ of the photothyristor 1 is expressed by the following equation:

$$\beta = I_A/I_G \quad \ldots\ldots\ldots \quad (1)$$

It is of course desirable for the value of $\beta$ to be large. $\beta$ max in relation to the abovedescribed $t_{stg}$ in the first stage is expressed by equation (2) below, and $\beta$max in the second stage is expressed by equation (3) below:

$$\beta max = 1 + 4L_n^2/W_p^2 \quad \ldots\ldots\ldots \quad (2)$$

$$\beta max^* = \alpha npn/ \ (\alpha npn + \alpha pnp - 1) \ \ldots \ (3)$$

where $W_p$ represents width of the p-base below $n_E$ region (e.g. the N-type region corresponding to the emitter of $TR_2$), $\alpha npn$ and $\alpha pnp$ represent respectively $\alpha$'s of npn and pnp parts of the thyristor. $\beta$ max in relation to a GTO (gate-turn-OFF) element takes the smaller value of $\beta$ max and $\beta$ max*. It is necessary to increase $\beta$ in order to increase the thyristor current which can be turned-OFF and for that purpose, a design based on equation (3) to obtain a high value $\alpha$ npn and low value $\alpha$ pnp will suffice. In order to facilitate extraction of excess carriers in the base, a comb-teeth type electrode pattern as practiced in GTO (gate-turn-OFF thyristor) is desirable, but it is to be noted that an appropriate hole must be provided to allow incident light to strike $P_B$-$N_B$ junction.

As has been explained above, in an optical coupling device of the present invention, a photothyristor may readily be switched from ON state to OFF state by means of gate control as is the case with a gate-turn-OFF (GTO) thyristor by placing in parallel to the photothyristor, between gate and cathode thereof, a photodetector element the impedance of which is decreased by incident light. It will be understood that a reference to a photothyristor includes a reference to a phototriac.

With the photodetector element of the invention, turn-OFF may be relatively difficult as explained above if the thyristor current is too large, but experimentally it has been confirmed that turn-OFF is possible with 60mA thyristor current. The value of thyristor current which can be turned-OFF depends on the structure of the device, so that further increase of this value can be expected. Moreover, by using light emitting diodes $LED_1$ and $LED_2$ in the present invention to control turn-ON and turn-OFF, a load circuit and a control circuit are completely isolated electrically to offer superior insulation characteristics.

CLAIMS

1.  An optical coupling device comprising a photothyristor, characterised in that a photodetector
element, the impedance of which/is decreased when light is
incident thereupon, is connected in parallel between
a gate and a cathode or an anode of the photothyristor.

2.  An optical coupling device as claimed in claim 1,
wherein the photodetector element is a bipolar
phototransistor, and wherein an element operable
to emit light when a signal for turning OFF the photothyristor is applied thereto is arranged opposite to
the phototransistor.

3.  An optical coupling device as claimed in claim 1
wherein the photodetector element is an enhancement
type photo-field effect transistor, and wherein an
element operable to emit light when a signal for
turning OFF the photothyristor is applied thereto
is arranged opposite to the field effect transistor.

4.  An optical coupling device as claimed in claim 1,
wherein the photothyristor is a photo-triac.

5.  An optical coupling device comprising photo-
sensitive means having first and second main terminals,
which means are placed in a first state (to pass or
block current flowing between the first and second
main terminals) when light is incident thereupon,
the photo-sensitive means also having a control terminal,
with a photodetector element connected in parallel
between the control terminal and one of the first and
second main terminals such that when light is incident
upon the photodetector element the resulting change in
impedance thereof causes the photosensitive means to
change from the first state to a second state (i.e.
to block or to pass current flowing between first
and second main terminals).

FIG. 1

FIG. 2

FIG. 3

FIG.4

FIG.5

FIG.6

F I G.7

$I_{F1}$

$I_{F2}$

$I_A$

F I G.8

N = 40

Number of turn-OFF's

15

10

5

0    20    40    60 mA    $I_{AMAX}$

FIG.9

N=10

FIG.10

| Category | DOCUMENTS CONSIDERED TO BE RELEVANT | | CLASSIFICATION OF THE APPLICATION (Int. Cl.3) |
|---|---|---|---|
| | Citation of document with indication, where appropriate, of relevant passages | Relevant to claim | |
| X | EDN ELECTRICAL DESIGN NEWS, vol. 20, no. 3, 5th February 1975, Denver US RIDDLE: "Opto-isolators switch high-voltage dc current", page 54 <br> * Page 54; figure and upper part * | 1,2,5 | H 03 K 17/78 |
| | US - A - 4 129 785 (KADAH) <br> * Figure; column 2, line 36 - column 3, line 24 * | 1,2,5 | |
| | PROCEEDINGS OF THE 10th CONFERENCE ON SOLID STATE DEVICES, Tokyo 1978, Japanese Journal of Applied Physics, vol. 18, supplement 18-1, 1979 (received EPO 10th July 1979) Tokyo JP SUGAWARA et al.: "Integrated Photo-coupled Semiconductor Crosspoint Switches", pages 405-410. <br> * Figure 7; page 407, last line to page 408, right-hand column, line 20 * | 1,2,5 | **TECHNICAL FIELDS SEARCHED (Int. Cl.3)** <br><br> H 03 K 17/78 |
| | US - A - 3 663 838 (REIMERS) <br> * Figure 2; column 1, line 55 - column 3, line 38 * | 1,3 | **CATEGORY OF CITED DOCUMENTS** <br> X: particularly relevant <br> A: technological background <br> O: non-written disclosure <br> P: intermediate document <br> T: theory or principle underlying the invention <br> E: conflicting application |
| | US - A - 3 693 060 (JOYCE) <br> * Figure 1, column 3, lines 10-63 * | 1,3 | D: document cited in the application <br> L: citation for other reasons |

The present search report has been drawn up for all claims

| Place of search | Date of completion of the search | Examiner |
|---|---|---|
| The Hague | 05-12-1980 | LEDRUT |

EPO Form 1503.1  06.78

| Category | DOCUMENTS CONSIDERED TO BE RELEVANT | | CLASSIFICATION OF THE APPLICATION (Int. Cl. 3) |
|---|---|---|---|
| | Citation of document with indication, where appropriate, of relevant passages | Relevant to claim | |
| | DE - A - 2 738 186 (HITACHI)<br><br>* Figures 1,5; page 7, last paragraph - page 9, first paragraph; page 12, last paragraph - page 13, first paragraph *<br><br>& US - A - 4 176 288 | 1,4 | |
| | US - A - 4 039 863 (OHHINATA)<br><br>* Figures 5,11,12; column 4, lines 28-38 * | 1,2 | **TECHNICAL FIELDS SEARCHED (Int. Cl. 3)** |
| | ELECTRONIQUE INDUSTRIELLE ,no. 112, April 1968, Paris FR CHARLES: "Quelques idées d'application des photothyristors" pages 213-215<br><br>* Page 214; figures 4a-4b * | 1,5 | |

EPO Form 1503.2  06.78